(19) Europäisches Patentamt
European Patent Office
Office européen des brevets

(11) **EP 1 522 102 B1**

(12) **EUROPÄISCHE PATENTSCHRIFT**

(45) Veröffentlichungstag und Bekanntmachung des Hinweises auf die Patenterteilung:
**07.05.2014 Patentblatt 2014/19**

(21) Anmeldenummer: **03763825.1**

(22) Anmeldetag: **11.07.2003**

(51) Int Cl.:
*H01L 29/732* (2006.01)     *H01L 29/167* (2006.01)

(86) Internationale Anmeldenummer:
**PCT/EP2003/007553**

(87) Internationale Veröffentlichungsnummer:
**WO 2004/008543 (22.01.2004 Gazette 2004/04)**

(54) **BIPOLARTRANSISTOR**

BIPOLAR TRANSISTOR

TRANSISTOR BIPOLAIRE

(84) Benannte Vertragsstaaten:
**DE FR IT**

(30) Priorität: **11.07.2002 DE 10231407**

(43) Veröffentlichungstag der Anmeldung:
**13.04.2005 Patentblatt 2005/15**

(73) Patentinhaber: **Infineon Technologies AG**
**85579 Neubiberg (DE)**

(72) Erfinder:
• **BÖCK, Josef**
**81827 München (DE)**
• **MEISTER, Thomas**
**82024 Taufkirchen (DE)**
• **ROMANYUK, Andriy**
**83727 Schliersee (DE)**
• **SCHÄFER, Herbert**
**85635 Höhenkirchen-Siegertsbrunn (DE)**

(74) Vertreter: **Banzer, Hans-Jörg**
**Kraus & Weisert**
**Patent- und Rechtsanwälte**
**Thomas-Wimmer-Ring 15**
**80539 München (DE)**

(56) Entgegenhaltungen:
**EP-A- 0 646 952     DE-A- 4 309 898**
**US-A- 4 437 897     US-A- 5 049 964**
**US-A- 5 541 444**

• **LEE L S ET AL: "ARGON ION-IMPLANTATION ON POLYSILICON OR AMORPHOUS-SILICON FOR BORON PENETRATION SUPPRESSION IN P+ PMOSFET" IEEE TRANSACTIONS ON ELECTRON DEVICES, IEEE INC. NEW YORK, US, Bd. 45, Nr. 8, 1. August 1998 (1998-08-01), Seiten 1737-1744, XP000782428 ISSN: 0018-9383**

**Beschreibung**

Die vorliegende Erfindung betrifft einen Bipolartransistor, der insbesondere in Form eines so genannten selbstjustierten Bipolartransistors ausgebildet sein kann.

Bei Bipolartransistoren ist der so genannte Basisbahnwiderstand (nachfolgend kurz als 'Basiswiderstand' bezeichnet) neben der Transitfrequenz und der Basis-Kollektor-Kapazität eine der entscheidenden Transistorparameter, welche wichtige Kenngrößen wie die maximale Oszillationsfrequenz, die Verstärkung ('Gain'), die minimale Rauschzahl, Gatterverzögerungszeiten, etc. des Bipolartransistors bestimmen. Dabei entspricht der Basiswiderstand dem Widerstand zwischen der Basis bzw. dem eigentlichen Basisbereich und einem externen Kontakt, der über eine Verbindungsleitung mit der Basis verbunden ist.

Hinsichtlich der zuvor erwähnten Transistorparameter gilt beispielsweise für die maximale Oszillationsfrequenz $f_{max}$ des Bipolartransistors:

$$f_{max} \approx \sqrt{\frac{f_T}{8\pi \cdot R_B \cdot C_{BC}}} \qquad , \qquad \qquad \ldots (1)$$

wobei $f_T$ die Transitfrequenz, $R_B$ den Basiswiderstand und $C_{BC}$ die Basis-Kollektor-Kapazität des Bipolartransistors darstellen.

Für die minimale Rauschzahl $F_{min}$ eines Bipolartransistors gilt in Abhängigkeit von dem Basiswiderstand $R_B$ und der Frequenz $f$ :

$$F_{min} \approx 1 + \frac{1}{\beta} + \frac{f}{f_T} \cdot \sqrt{\frac{2 \cdot I_C}{V_T} \cdot R_B \cdot \left(1 + \frac{f_T^2}{\beta \cdot f^2}\right) + \frac{f_T^2}{\beta \cdot f^2}} \qquad , \qquad \ldots (2)$$

mit $\beta$ als Kleinsignal-Stromvertäkung, $I_C$ als Kollektorstrom und $V_T$ als thermischer Spannung des Bipolartransistors.

Aus den beiden Formeln (1) und (2) ist ersichtlich, dass der Basiswiderstand $R_B$ für schnelle Schaltvorgänge und niedrige Rauschzahlen klein sein sollte. Ein Verfahren zum Reduzieren von Verlusten bei Bipolartransistoren ist die Verwendung einer Polysilizium-Elektrode zum Kontaktieren der Basis. Eine p+-Polysiliziumschicht sieht für den Basisstrom einen niederohmigen Pfad mit entsprechend geringer Kapazität vor.

Besonders kleine Basiswiderstände können beispielsweise durch Anwendung des Konzepts des sogenannten 'selbst justierten Doppelpolysilizium-Bipolartransistors' erzielt werden, wie es in "Self-Aligned Bipolar Transistors for High-Perormance and Low-Power-Delay VLSI", T.H. Ning et al., IEEE Transactions on Electron Devices, Vol. ED-28, No. 9, Seiten 1010-1013, 1981, beschrieben ist. Dieses Konzept findet daher in nahezu allen gängigen Produktionstechnologien für Höchstfrequenz-Bipolartransistoren Verwendung.

In der beiliegenden Figur ist ein derartiger selbstjustierter npn-Doppelpolysilizium-Bipolartransistor in Querschnittsansicht dargestellt. Der Emitter 3 wird über eine n+-dotierte Polysilizium-Elektrode 1 kontaktiert. Der p+-dotierten Basis 4 ist eine p+-Polysilizium-Elektrode 2 zugeordnet. Die selbstjustierte Emitter-Basis-Isolation 7 wird als 'Spacer' bezeichnet. Ferner sind unter der Emitterelektrode 3 eine TEOS ('Tetraethoxysilan/Tetraethylorthosilikat') - Isolationsschicht 6 und unter der Basiselektrode 2 eine LOCOS ('Local Oxidation of Silicon') - Isolationsschicht 8 vorgesehen. In der Figur ist ebenfalls gestrichelt der Kollektorbereich 5 des Bipolartransistors (ohne zugehörige Kollektorelektrode) angedeutet. Ein Verfahren zur Herstellung eines derartigen Bipolartransistors ist zum Beispiel in der EP-B1-0 535 350 beschrieben.

Bei einem selbstjustierten Doppelpolysilizium-Bipolartransistor, wie er in der Figur dargestellt ist, setzt sich der Basiswiderstand $R_B$ im wesentlichen aus drei Anteilen zusammen, die im Folgenden als 'innerer' Widerstandsanteil $R_{Bi}$, als 'externer' Widerstandsanteil $R_{Be}$ und als 'Link'-Widerstandsanteil $R_{Bl}$ bezeichnet werden. Der innere Widerstandsanteil $R_{Bi}$ entsteht durch den Widerstand im Basisgebiet 4 am aktiven Transistorbereich. Der externe Widerstandsanteil $R_{Be}$ beschreibt den Widerstand der Polysilizium-Basiselektrode 2, welche zu dem externen Basiskontakt führt. Der Link-Widerstandsanteil $R_{Bl}$ stellt den Basiswiderstand dar, der durch die niedrig dotierte Zone unter der selbstjustierten Emitter-Basis-Isolation, den Spacern 7, entsteht.

Bei heutigen Bipolartransistoren wird der gesamte Basiswiderstand $R_B$ in der Regel durch die Summe aus dem inneren Widerstandsanteil $R_{Bi}$ und dem Link-Widerstandsanteil $R_{Bl}$ dominiert. Aufgrund fortschreitender lateraler Skalierung der Bauteile werden auch der innere Widerstandsanteil $R_{Bi}$ und der Link-Widerstandsanteil $R_{Bl}$ kontinuierlich reduziert. Gleichzeitig wird der externe Widerstandsanteil $R_{Be}$ immer größer, da die mit der lateralen Skalierung verknüpfte vertikale Bauteilskalierung immer dünnere Polysiliziumschichten als Anschlusselektroden erfordert und der Schichtwiderstand dieser Anschlussgebiete damit immer größer wird. Somit gewinnt der externe Widerstandsanteil $R_{Be}$ für den gesamten Basiswiderstand $R_B$ immer mehr an Bedeutung.

Um den Schichtwiderstand der Basiselektrode 2 möglichst gering zu halten, werden im allgemeinen mit Bor dotierte Polysiliziumschichten verwendet, wobei die Bor-Dotierung über der elektrisch aktivierbaren Konzentration von typischerweise größer als $5 \times 10^{20}$ cm$^{-3}$ gewählt wird, um den kleinstmöglichen Schichtwiderstand zu erzielen. Man wählt das Bor-Dotieratom aufgrund der Überlegung, dass Bor wenig oder gar keine Auswirkungen auf das Kornwachstum hat und nicht dazu neigt, sich während thermischer Bearbeitungsvorgänge an Korngrenzen abzusondern. Das Modell der Dotierstoffabsonderung nimmt an, dass die Leitfähigkeit durch Absonderung von Dotieratomen zu den Korngrenzen gesteuert wird, wo die Atome selbst gefangen werden und elektrisch inaktiv werden. Außerdem unterdrückt eine hohe Dotierstoffkonzentration an den Korngrenzen das Kornwachstum während des Aushärtens ("Annealing"). Rückverteilung implantierter Dotierstoffe und größere Korngrößen während anschließender Aushärtungsschritte verändern die elektrischen und strukturellen Eigenschaften der Schichten, was den externen Widerstandsanteil $R_{Be}$ des Basiswiderstands $R_B$ deutlich beeinflusst. Das Hauptproblem stellt das Aushärtungsverhalten von Si-Proben mit Dotieratomen dar. Tatsächlich ist nur ein kleiner Anteil von etwa 10% der Dotieratome ionisiert. Es wird angenommen, dass inaktive, nichtausgeschiedene Dotieratome in Clusterform vorliegen; die Clusterbildung der Dotieratome findet bei der Aushärtungstemperatur oder alternativ hauptsächlich während des Abkühlens der Probe statt. Bei typischen Dotierungswerten von Bor größer als $5 \times 10^{20}$ cm$^{-3}$ und einer Schichtdicke von 150-250 nm können minimale Schichtwiderstände von etwa 50-100 $\Omega/\square$ erzielt werden.

Außerdem offenbart das Dokument US-A-5 541 444 einen Bipolartransistor gemäß dem Oberbegriff des Anspruchs 1. Als Elektrode für den Emitter offenbart dieses Dokument eine dünne n$^+$- Halbleiterschicht mit einer Bandlücke, die größer als diejenige von Silizium ist und die beispielsweise aus einkristallinem Material oder polykristallinem Material aus $Si_xC_{1-x}Ge_y$ (0<x<1 and 0<y<1) oder polykristallinem $Si_x C_{1-x}$:H Material besteht.

Der vorliegenden Erfindung liegt die Aufgabe zugrunde, einen Bipolartransistor bereitzustellen, bei dem der Schichtwiderstand der Anschlusselektroden, insbesondere der Basiselektrode, weiter reduziert ist.

Diese Aufgabe wird gemäß der Erfindung durch einen Bipolartransistor mit den Merkmalen von Anspruch 1 gelöst. In den Unteransprüchen sind bevorzugte und vorteilhafte Ausführungsformen der vorliegenden Erfindung angegeben.

Erfindungsgemäß wird vorgeschlagen, bei Bipolartransistoren anstelle herkömmlicher Polysiliziumelektroden Polysiliziumschichten zu verwenden, in welche Fremdatome eingebracht sind, welche eine hohe Dichte an Gitterleerstellen im Elektrodenmaterial bewirken.

Als Fremdatome werden C- oder Ar-Atome,besonders bevorzugt C-Atome, verwendet. Die Dichte der Fremdatome in der Polysiliziumschicht liegt dabei im Bereich von $10^{19}$-$10^{21}$ cm$^{-3}$.

Kohlenstoff mit einer hohen Löslichkeit in Silizium kann in dem Siliziumgitter sowohl an Zwischengitterplätzen als auch an den energetisch günstigeren Gitterplätzen im Austausch für ein Si-Atom eingebaut werden. Die C-Atome auf den Gitterplätzen fangen auf Zwischengitterplätzen vorhandene Si-Atome ein und bilden somit gebundene Zwischengitterkomplexe. Aufgrund dieses Einfangmechanismus der C-Atome werden zusätzliche Gitterleerstellen erzeugt. Daher sieht der Kohlenstoff in der Polysiliziumschicht während des Aushärtens Senken für Zwischengitterplätze vor, wodurch eine Zwischengitterplatz-getriebene Clusterbildung von beispielsweise Bor-Dotieratomen unterdrückt und damit die Menge und somit die Konzentration aktiver Dotieratome erhöht werden kann. Dies führt zu einem niedrigeren Schichtwiderstand der beispielsweise mit Bor dotierten Polysiliziumschicht und somit zu einem kleineren Basiswiderstand. Dieser Effekt kann durch die Verwendung von Polysiliziumschichten aus polykristallinem Silizium-Germanium noch erhöht werden.

Da Kohlenstoff in der Halbleitertechnik allgemein verwendet wird und sowohl direkt während des Schichtwachstums als auch durch Ionenimplantation in die Polysiliziumschicht der Elektroden eingebracht werden kann, kann das oben beschriebene Konzept der Erfindung einfach und kostengünstig in Herstellungsverfahren von herkömmlichen Bipolartransistoren implementiert werden.

Ein weiterer Vorteil liegt darin, dass C-Atome ohne wesentliche Störung des Si-Gitteraufbaus eingebaut werden können, da selbst SiC nur ein um etwa 3% größeres Volumen als reines Si besitzt.

Die vorliegende Erfindung bezieht sich auf Bipolartransistoren. Gundsätzlich, aber nicht beansprucht, ist auch der Einsatz bei anderen Transistorarten wie beispielsweise FET-, MOS- oder CMOS-Transistoren denkbar.

Die Erfindung wird nachfolgend unter Bezugnahme auf die einzige Figur eines bevorzugten Ausführungsbeispiels näher erläutert.

Hinsichtlich des in der Figur dargestellten Ausführungsbeispiels kann zur Vermeidung von Wiederholungen weitgehend auf die obigen Ausführungen zum Stand der Technik verwiesen werden. In der Figur ist - wie bereits zuvor erwähnt - ein selbstjustierter npn-Bipolartransistor in Querschnittsdarstellung gezeigt.

Der Emitter 3 des Bipolartransistors ist über eine $n^+$- dotierte Polysilium-Elektrode 1 kontaktiert, und der $p^+$-dotierten Basis 4 ist eine $p^+$-dotierte Polysilizium-Elektrode 2 zugeordnet. Spacer 7 sind als selbstjustierte Emitter-Basis-Isolation vorgesehen. Darüber hinaus ist unter der Emitterelektrode 1 eine TEOS-Isolationsschicht 6 und unter der Basiselektrode 2 eine LOCOS-Isolationsschicht 8 vorgesehen. In der Figur ist ebenfalls der Kollektorbereich 5 des Bipolartransistors (gestrichelt) angedeutet.

Als Basiselektrode 2 wird eine Polysiliziumschicht verwendet, in die C-Fremdatome mit einer Konzentration von $10^{19}$-$10^{21}$ $cm^{-3}$ eingebracht worden sind. Dies kann entweder mittels Ionenimplantation oder alternativ ohne zusätzlichen Implantationsschritt direkt während des Schichtwachstums erfolgen. Zusätzlich wird die Polysiliziumschicht, wie bereits bekannt, mit Bor-Atomen in einer Konzentration von größer als $5 \times 10^{20}$ $cm^{-3}$ dotiert.

Die C-Fremdatome lagern sich an Zwischengitterplätzen und bevorzugt an den energetisch günstigeren Gitterplätzen in das Si-Gitter ein. Die C-Fremdatome auf den Gitterplätzen fangen Si-Atome von Zwischengitterplätzen ein und bilden gebundene Zwischengitterkomplexe. Aufgrund dieser eingefangenen Si-Atome werden zusätzliche Gitterleerstellen mit einer geschätzten Dichte von etwa $10^{19}$ $cm^{-3}$ erzeugt. Die so gebildeten Si-C-Agglomerate sind bis etwa 700°C stabil, bei höheren Temperaturen wandeln sie sich in $\beta$-SiC um, wobei das im Vergleich zu der Si-Matrix um etwa 3% etwas größere Volumen von SiC ebenfalls durch Gitterstellen leicht kompensiert werden kann, so dass keine unerwünschten Spannungen in den Elektroden entstehen. Der Kohlenstoff erzeugt auf diese Weise während des Aushärtens in der Polysiliziumschicht Senken für Zwischengitterplätze, wodurch eine Zwischengitterplatz-getriebene Clusterbildung der Bor-Dotieratomen unterdrückt und damit die Menge aktiver Dotieratome erhöht werden kann.

Die so erzeugte höhere Konzentration aktiver Dotieratome führt zu einem niedrigeren Schichtwiderstand der mit Bor dotierten Polysiliziumschicht und somit zu einem kleineren Basiswiderstand. Dieser Effekt kann durch die Verwendung von Polysiliziumschichten aus polykristallinem Silizium-Germanium noch erhöht werden.

Selbstverständlich können alternativ oder zusätzlich zu der Basiselektrode 2 auch die Emitterelektrode 1 und die Kollektorelektrode in der erfindungsgemäßen Weise ausgebildet werden.

## Patentansprüche

1. Bipolartransistor,
mit einem über eine Emitterelektrode (1) elektrisch kontaktierbaren Emitterbereich (3);
mit einem über eine Basiselektrode (2) elektrisch kontaktierbaren Basisbereich (4); und
mit einem über eine Kollektorelektrode elektrisch kontaktierbaren Kollektorbereich (5),
wobei wenigstens eine Elektrode der Emitter-, Basis- und Kollektorelektroden (1, 2) eine Polysiliziumschicht ist, in welche eine Dotierung eingebracht ist,
**dadurch gekennzeichnet,**
**dass** in die wenigstens eine Elektrode zusätzlich zu der Dotierung Fremdatome mit einer Dichte von $10^{19}$-$10^{21}$ $cm^{-3}$ eingebracht sind, wobei die Fremdatome C- oder Ar-Atome sind.

2. Bipolartransistor nach Anspruch 1,
**dadurch gekennzeichne**t,
dass die Polysiliziumschicht mit Bor-Atomen dotiert ist.

3. Bipolartransistor nach Anspruch 2,
**dadurch gekennzeichnet,**
**dass** die Konzentration der Bor-Atome größer als $5 \times 10^{20}$ $cm^{-3}$ gewählt ist.

4. Bipolartransistor nach einem der vorhergehenden Ansprüche,
**dadurch gekennzeichnet,**
**dass** die wenigstens eine Elektrode (1, 2) aus polykristallinem Silizium-Germanium besteht.

5. Bipolartransistor nach einem der vorhergehenden Ansprüche,
**dadurch gekennzeichnet,**
**dass** die wenigstens eine Elektrode die Basiselektrode (2) ist.

6. Bipolartransistor nach einem der vorhergehenden Ansprüche,
**dadurch gekennzeichnet,**
**dass** der Bipolartransistor ein selbstjustierter Bipolartransistor ist.

**Claims**

1. Bipolar transistor,
   comprising an emitter region (3), with which electrical contact can be made via an emitter electrode (1);
   comprising a base region (4), with which electrical contact can be made via a base electrode (2); and
   comprising a collector region (5), with which electrical contact can be made via a collector electrode,
   wherein at least one electrode of the emitter, base and collector electrodes (1, 2) is a polysilicon layer into which a doping is introduced,
   **characterized**
   **in that**, in addition to the doping, impurity atoms with a density of $10^{19}$ - $10^{21}$ $cm^{-3}$ are introduced into the at least one electrode, wherein the impurity atoms are C or Ar atoms.

2. Bipolar transistor according to Claim 1,
   **characterized**
   **in that** the polysilicon layer is doped with boron atoms.

3. Bipolar transistor according to Claim 2,
   **characterized**
   **in that** the concentration of the boron atoms is chosen to be greater than $5 \times 10^{20}$ $cm^{-3}$.

4. Bipolar transistor according to any of the preceding claims,
   **characterized**
   **in that** the at least one electrode (1, 2) consists of polycrystalline silicon-germanium.

5. Bipolar transistor according to any of the preceding claims,
   **characterized**
   **in that** the at least one electrode is the base electrode (2).

6. Bipolar transistor according to any of the preceding claims,
   **characterized**
   **in that** the bipolar transistor is a self-aligned bipolar transistor.

**Revendications**

1. Transistor bipolaire,
   comprenant une zone (3) d'émetteur pouvant être mise en contact électriquement par l'intermédiaire d'une électrode (1) d'émetteur ;
   comprenant une zone (4) de base pouvant être mise en contact électriquement par l'intermédiaire d'une électrode (2) de base ; et
   comprenant une zone (5) de collecteur pouvant être mise en contact électriquement par l'intermédiaire d'une électrode de collecteur,
   dans lequel au moins une électrode parmi les électrodes (1, 2) d'émetteur de base et de collecteur est une couche de polysilicium dans laquelle est introduite un dopage, **caractérisé**
   **en ce que** dans la au moins une électrode sont introduits supplémentairement au dopage des atomes étrangers en une teneur de $10^{19}$ à $10^{21}$ $cm^{-3}$, les atomes étrangers étant des atomes de C ou des atomes d'Ar.

2. Transistor bipolaire suivant la revendication 1, **caractérisé en ce que** la couche de polysilicium est dopée par des atomes de bore.

3. Transistor bipolaire suivant la revendication 2, caractérisé en ce la concentration en atomes de bore est plus grande que $5 \times 10^{20}$ $cm^{-3}$.

4. Transistor bipolaire suivant l'une des revendications précédentes, **caractérisé en ce que** la au moins une électrode (1, 2) est en silicium-germanium polycristallin.

5. Transistor bipolaire suivant l'une des revendications précédentes, **caractérisé en ce que** la au moins une électrode est l'électrode (2) de base.

**6.** Transistor bipolaire suivant l'une des revendications précédentes, **caractérisé en ce que** le transistor bipolaire est un transistor bipolaire à auto-alignement.

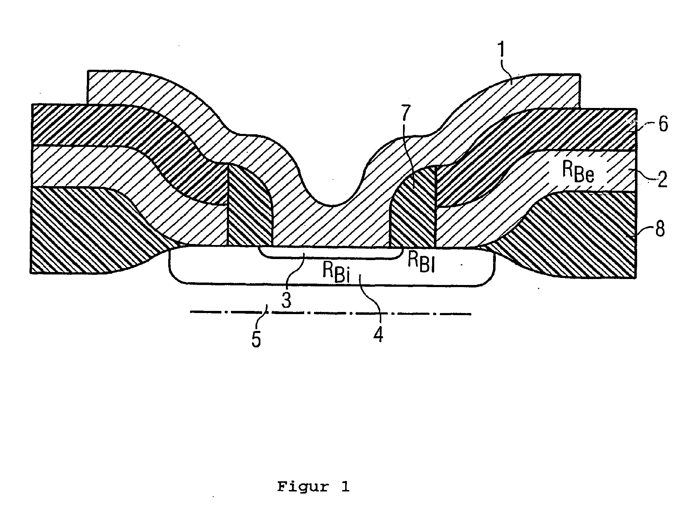

Figur 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0535350 B1

- US 5541444 A

**In der Beschreibung aufgeführte Nicht-Patentliteratur**

- **T.H. NING et al.** Self-Aligned Bipolar Transistors for High-Perormance and Low-Power-Delay VLSI. *IEEE Transactions on Electron Devices,* 1981, vol. ED-28 (9), 1010-1013